# EUROPEAN PATENT APPLICATION

(11) **EP 3 524 928 A1**
(43) Date of publication of application: **14.08.2019**
(21) Application number: 17894659.6
(22) Date of filing: 20.12.2017
(51) Int. Cl.: G01B 11/24, G01B 11/30, B07C 5/10

(54) **FULLY AUTOMATIC SUBSTRATE SIZE DETECTION APPARATUS, SUBSTRATE DETECTION LINE AND DETECTION METHOD THEREOF**

(30) Priority: 14.12.2017 CN 201711341674
(71) Applicant: Beijing Apollo Ding Rong Solar Technology Co., Ltd., Beijing 100176 (CN)
(72) Inventor: QI, Weibin, Beijing 100176 (CN); LIN, Jian, Beijing 100176 (CN); ZHANG, Xueliang, Beijing 100176 (CN); WANG, Hong, Beijing 100176 (CN); JIANG, Wei, Beijing 100176 (CN); LV, Hejiang, Beijing 100176 (CN); LIN, Junrong, Beijing 100176 (CN)
(74) Representative: Cabinet Beau de Loménie
(86) International application number: PCT/CN2017/117414
(87) International publication number: WO 2019/114010

(57) **Abstract**

The present disclosure discloses a fully-automatic device for detecting substrate size, a substrate detection line and a detecting method thereof. The fully-automatic device for detecting substrate size includes a main frame, a load plate, a conveying belt, a gate-type travelling mechanism and a laser sensor. A plurality of the load plates are fixed on the main frame, and one conveying belt is arranged between two adjacent load plates, and a travelling rail is arranged on the load plates located on both sides and along the length direction thereof, and the gate-type travelling mechanism is mounted on the travelling rail, and the laser sensor is mounted on the gate-type travelling mechanism through a third travelling mechanism. The present disclosure can automatically detect the substrate size instead of manual work, and thereby having advantages of fast detection speed and high detection accuracy.

## Description

### TECHNICAL FIELD

This disclosure relates to a field of a mechanical device, and in particular to a fully-automatic device for detecting substrate size, a substrate detection line and a detecting method thereof.

### BACKGROUND

With rapid advancement of science and technology, people's awareness of environmental protection is rapidly increasing. Substituting new energy for non-renewable energy such as fossils becomes a general trend. A thin-film battery is a high-tech achievement to generate electricity by using solar energy. After entering the 21st century, a conversion efficiency of thin-film battery has reached an unprecedented rapid development.

The thin-film battery is one kind of solar cells, and has a complicated preparation process. All of the PVD (Physical Vapor Deposition) plating film, TCO transparent conductive plating film, and CIGS solar thin-film battery plating film have very strict requirements for dimensional accuracy of materials. In order to ensure normal operation of the most important deposition process, it is necessary that a first-stage substrate conforms to the process requirements. The existing drive line does not include an automatic detection device for the substrate size, but only sample inspection made by operators when the raw materials are put into the warehouse or qualified certification documents provided by the raw material manufacturers, so that the dimensional accuracy of the materials cannot be guaranteed, and thereby it is urgent to develop a fully-automatic device for detecting material size.

### SUMMARY

One object of the present disclosure is to provide full automatic device for detecting substrate size to solve the deficiencies in the prior art, which can replace the manual automatic detection of substrate size, and have the advantages of high detection speed and high detection accuracy.

Another object of the present disclosure is to provide a detection line, which can be automatically fed, automatically detect and automatically discharge, effectively improving the substrate detection efficiency.

Another object of the present disclosure is to provide a method for detecting a detection line, which can accurately detect the size of a substrate, and realize automatic feeding and automatic discharging.

The disclosure provides a fully-automatic device for detecting substrate size, comprising a main frame, a plurality of load plates, at least one conveying belt, a gate-type travelling mechanism, a laser sensor, two travelling rails, and a third travelling mechanism; wherein the plurality of load plates are fixed on the main frame at an equal distance; one of the at least one conveying belt is disposed between the two of the plurality of load plates adjacent to each other; the travelling rails are arranged on two of the plurality of the load plates located on both sides of the main frame and along a length direction of the load plates; the gate-type travelling mechanism is mounted on the travelling rails; and the laser sensor is mounted on the gate-type travelling mechanism through the third travelling mechanism.

In an optional embodiment, the gate-type travelling mechanism comprises a first travelling mechanism, a second travelling mechanism and a cross beam; the cross beam is located above the load plates; and the first travelling mechanism is fixedly installed at one end of the cross beam, and the second travelling mechanism is fixedly installed at another end of the cross beam; the first travelling mechanism and the second travelling mechanism respectively cooperate with the two travelling rails; a second travelling rail is provided on one side of the cross beam; the third travelling mechanism is mounted on the second travelling rail; and the laser sensor is fixedly installed on the third travelling mechanism.

In an optional embodiment, each of the travelling rails has a monorail structure fixed on an outer side of one of the plurality of load plates; the first travelling mechanism has the same structure as the second travelling mechanism, the first travelling mechanism and the second travelling mechanism comprise a first frame, two upper travelling wheels, two lower travelling wheels and a first servo motor; the two upper travelling wheels and the two lower travelling wheels are installed at a lower part of an inner side surface of the first frame; the two upper travelling wheels are connected with top surfaces of the travelling rails in a rolling manner; the two lower travelling wheels are connected with bottom surfaces of the travelling rails in a rolling manner; a first rack is further provided on an outer side surface of one of the load plates; the first servo motor is also fixedly disposed on the inner side surface of the first frame; a first output gear is provided on an output shaft of the first servo motor, and is engaged with the first rack.

In an optional embodiment, the third travelling mechanism comprises a second frame, a slider and a second servo motor, wherein the slider and the second servo motor are both fixedly installed on the second frame, and the second travelling rail has a dual rail structure and the slider is slidably mounted on the second travelling rail, and a side of the cross beam is also provided with a second rack arranged in parallel with the second travelling rail, and a second output gear is provided on an output shaft of the second servo motor, and the second output gear is engaged with the second rack, and the laser sensor is fixedly disposed on the second frame.

In an optional embodiment, a groove is opened on one of the plurality of load plates, and the groove is located at a feeding end of the plurality of load plates, and a position sensor is provided in the groove.

In an optional embodiment, a positioning mechanism is provided at a bottom portion of the outermost one of the plurality of load plates; the positioning mechanism is mounted at the bottom portion of the outermost one of the plurality of the load plates through the fourth travelling mechanism, and is capable of moving in a width direction of the load plates; a plurality of through holes are arranged on the surface of one of the load plates at equal distances along a length direction thereof; and each of the through holes is arranged in a width direction of the load plates; the positioning mechanism comprises a third frame, two cam mounting rods, two cams, a support rod, a plurality of push rods, and a third servo motor; a plurality of guide holes corresponding to the through holes one by one are provided on a top rod of the third frame; one of the push rods is mounted in each of the guide holes; the two cam mounting rods are fixedly disposed at a bottom portion of the third frame; one of the cams is mounted at a bottom portion of each of the two cam mounting rods; the support rod is located directly under the guide holes; one end of the support rod is connected with one of the two cams by one hinge and another end of the support rod is connected with the other of the two cams by another hinge; and the third servo motor is disposed on one of the cam mounting rods, for driving the cam mounted on one of the cam mounting rods.

In an optional embodiment, the fourth travelling mechanism comprises a fourth servo motor, a third rack and two third travelling rails; the two third travelling rails are arranged in the width direction of the load plates; two sliding sleeves are provided on the top portion of the third frame; the two sliding sleeves are respectively sleeved on the two third travelling rails; the third rack is also fixed on the bottom surface of the load plates and is parallel to the two third travelling rails; and the fourth servo motor is fixed on the top portion of the third frame and is engaged with the third rack.

The disclosure also provides a substrate detection line, which comprises an automatic feeding device, a substrate size detecting device and a material output station which are connected in sequence, wherein said substrate size detecting device adopts the aforementioned fully-automatic device for detecting substrate size.

In an optional embodiment, the substrate detection line further comprises an alarm device; the alarm device is a traffic light alarm device, and is fixed on the automatic feeding device.

A detection method applied in the aforementioned detection line comprises the following steps:

Taking pieces procedure, in which the automatic feeding device picks up a substrate from a material rack, reverses the substrate from the vertical direction to the horizontal direction, and horizontally places the substrate on the substrate size detecting device;

Detecting size procedure, in which a conveying belt on the substrate size detecting device transports the substrate to a preset position, and a laser sensor scans the four sides of the substrate one by one, and sends the collected data to a data processing device and calculates a length, width, and diagonal dimension of the substrate by the data processing device, and compares the calculation results with preset values to determine whether the substrate is qualified in size;

Discharging pieces procedure, in which the conveyor conveys the substrate to the material output station, and the material output station conveys the substrate according to the detection result fed back by the data processing device, wherein when the size of the substrate is qualified, the substrate is transferred to a next station, and when the size of the substrate is unqualified, the substrate is rotated by 90 degrees and transferred to a branch processing station.

Compared with the prior art, the present disclosure includes a main frame, a load plate, a conveyor belt, a gate-type traveling mechanism, and a laser sensor. The gate-type traveling mechanism can travel along the length of the main frame through the cooperation with the travelling rail on the load plate. The third traveling mechanism is provided on the travelling mechanism. The third travelling mechanism can travel along the gate-type travelling mechanism, that is, travel along the width of the main frame, so that the laser sensor can collect the position coordinates of the points on the substrate located on the load plate. The collected information is processed by the data processing means to obtain accurate substrate size information. By controlling the quality of the substrate, the quality of the thin film battery is further improved.

Since the substrate detection line provided by the present disclosure adopts the above full automatic device for detecting substrate size, it naturally has the above-mentioned effective effect.

The method for using the substrate detection line provided by the present disclosure can realize the automatic loading, automatic detection and automatic unloading of the substrate to realize the automatic detection of the substrate size.

### BRIEF DESCRIPTION OF THE DRAWINGS

Fig. 1 is an isometric view of the overall structure of the present disclosure;
Fig. 2 is a front view of the present disclosure;
Fig. 3 is a left side view of the present disclosure;
Fig. 4 is a schematic structural view of part A of Fig. 2 which is enlarged and partially sectioned;
Fig. 5 is a top view of the present disclosure;
Fig. 6 is a schematic structural view of part B of Fig. 3 which is enlarged and partially sectioned;
Fig. 7 is an isometric view of a positioning mechanism;
Fig. 8 is a top view of the present disclosure provided with a positioning mechanism;
Fig. 9 is a schematic structural view of a substrate detection line.

Reference numbers are described as follows: 1 - main frame, 2 - load plate, 3 - conveying belt, 4-gate-type travelling mechanism, 5 - laser sensor, 6 - travelling rail, 7 - first travelling mechanism, 8 - second travelling mechanism, 9-cross beam, 10 - third travelling mechanism, 11 - second travelling rail, 12 - first frame, 13 - upper travelling wheel, 14 - lower travelling wheel, 15 - first servo motor, 16 - first rack , 17 - first output gear, 18 - second frame, 19 - slider, 20 - second servo motor, 21 - second rack, 22 - second output gear, 23 - groove, 24 - position sensor, 25-third frame, 26-cam mounting rod, 27-cam, 28-support rod, 29-push rod, 30-third servo motor, 31-fourth servo motor, 32-third rack, 33 - third travelling rail, 34-through hole, 35-sliding sleeve, 36-guide hole, 37-automatic feeding device, 38- substrate size detecting device, 39- material output station, 40-air hole, 41-guard plate , 42- transmission shaft, 43- substrate.

### DETAILED DESCRIPTION

The embodiments described below with reference to the drawings are exemplary, are used to explain the present disclosure, and cannot be construed as limiting the present disclosure.

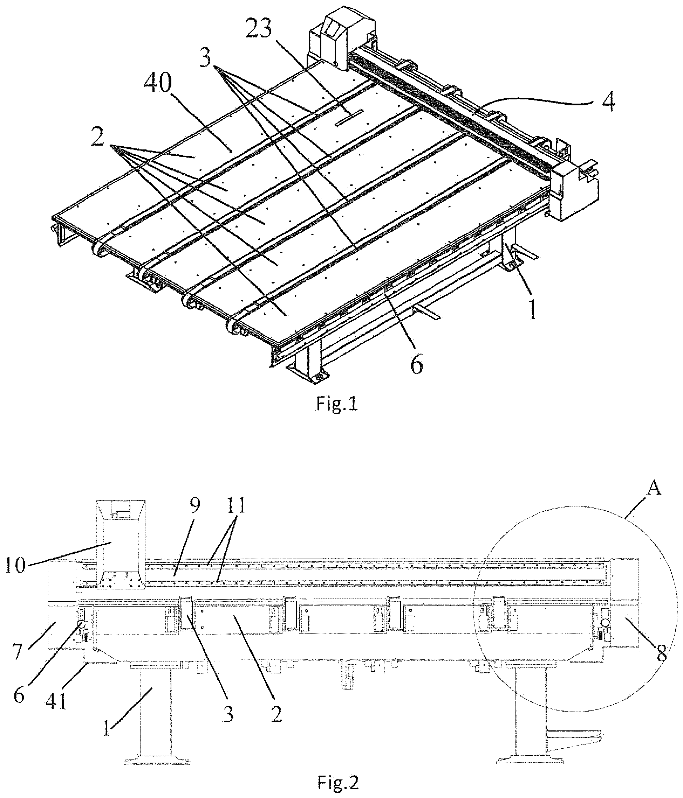

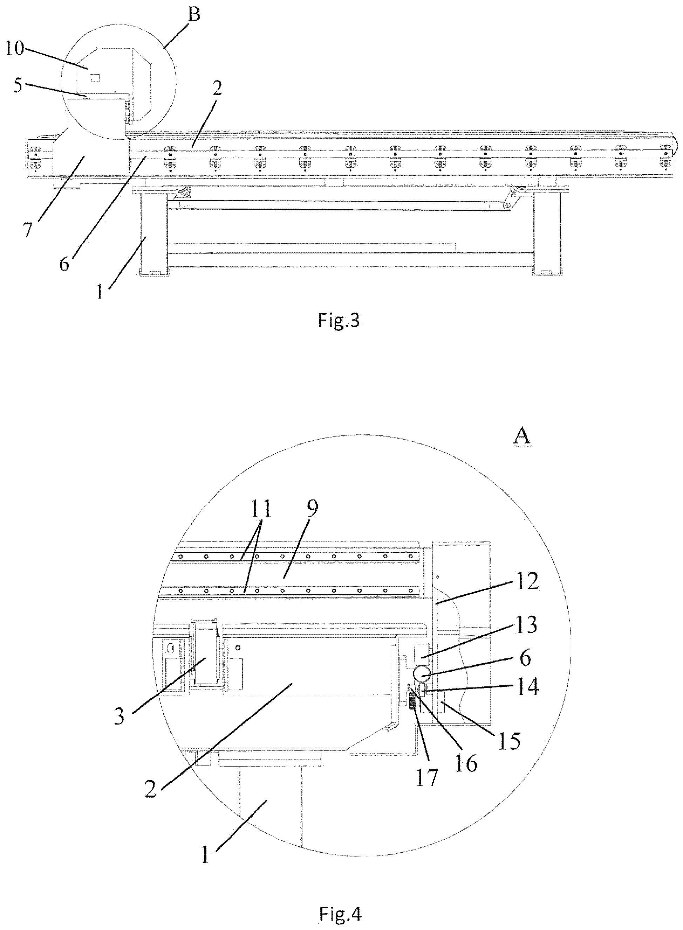

An embodiment of the present disclosure is provided as follows: as shown in Fig. 1 and Fig. 3, a fully-automatic device for detecting substrate size includes a main frame 1, a plurality of load plates 2, at least one conveying belt 3, a gate-type travelling mechanism 4, and a laser sensor 5. The plurality of load plates 2 are fixed on the main frame 1 at the same distance. One conveying belt 3 is disposed between two load plates 2 adjacent to each other. And a conveying direction of the conveying belt 3 is parallel to a length direction of the load plate. Two travelling rails 6 are respectively arranged on the load plates 2 on the two sides of the conveying belt 3 and is disposed along the length direction of the load plate. A gate-type travelling mechanism 4 is mounted on the travelling rails 6. A laser sensor 5 is mounted on the gate-type travelling mechanism 4 via a third travelling mechanism 10. It should be noted that the present disclosure also provides a data processing means. The laser sensor 5 is connected to the data processing means. Both the laser sensor 5 and the data processing means may be connected by a wire or wirelessly. The data processing means may be a smart device such as a desktop computer, a notebook computer or a tablet computer.

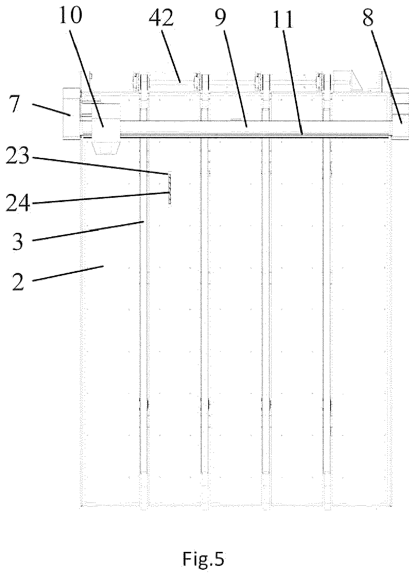

During operation, feeding is performed by a feeding device or by an operator. The substrate is transported to an appropriate position by the conveying belt 3, and then the conveying belt 3 stop working, and the gate-type travelling mechanism 4 is driven by its own drive device to move along the travelling rails 6, while the third travelling mechanism 10 is driven by its own drive device to move on the gate-type travelling mechanism 4, and at the same time, the laser sensor 5 scans four sides of the substrate, scanning position coordinates of the two end points on each side and transmitting the data to the data processing means, and then the data processing means obtains an exact size of the substrate through calculation. It should be noted that the data processing means is of the prior art but not shown in the drawings. The conveying belt 3 is also of the prior art. Each of conveying belts 3 may be provided with a separate drive device, or may adopt a structure as shown in Fig. 5, in which a transmission shaft 42 is used to connect the drive rollers of all conveying belts 3 so that only one drive unit is needed. With the present disclosure, the size information of each substrate to be processed can be obtained in real time, so that the quality of a thin-film battery can be improved.

In a specific implementation, please referring to Fig. 2, the gate-type travelling mechanism 4 includes a first travelling mechanism 7, a second travelling mechanism 8, and a cross beam 9. The cross beam 9 is located above the load plate 2, and arranged along a width direction of the load plate 2. The first travelling mechanism 7 is fixedly installed at one end of the cross beam 9, and the second travelling mechanism 8 is fixedly installed at another end of the cross beam 9. The first travelling mechanism 7 and the second travelling mechanism 8 respectively cooperate with the travelling rails 6 on the two outermost load plates 2. A second travelling rail 11 is provided on one side of the cross beam 9. The third travelling mechanism 10 is mounted on the second travelling rail 11. And the laser sensor 5 is fixedly installed on the third travelling mechanism 10.

As shown in Fig. 4, each of the travelling rails 6 has a monorail structure and is fixed on the outer side of the load plate 2. Each of the travelling rails 6 preferably adopts a cylindrical rail. The first travelling mechanism 7 and the second travelling mechanism 8 have the same structure and each includes the first frame 12, an upper travelling wheel 13, a lower travelling wheel 14 and a first servo motor 15. There are two upper travelling wheels 13 and two lower travelling wheels 14, which travelling are installed at the lower part of the inner side of the first frame 12. Of course, there are more than two travelling wheels, but two travelling wheels are the optimal solution, because the more the number, the higher the cost. However, the more the travelling wheel is, the travelling stability of the travelling mechanism can be improved accordingly. The two upper travelling wheels 13 are connected with top surfaces of the travelling rails 6 in a rolling manner. The two lower travelling wheels 14 are connected with bottom surfaces of the travelling rails 6 in a rolling manner. The upper travelling wheel 13 and the lower travelling wheel 14 are preferably formed by groove wheels. The outer surface of the load plate 2 is also provided with a first rack 16. The first servo motor 15 is also fixedly arranged on the inner side of the first frame 12. A first output gear 17 is provided on the output shaft thereof and engaged with the first rack 16.

When the first servo motor 15 rotates, the first output gear 17 is driven to rotate, and the first output gear 17 is engaged with the first rack 16, so that the first travelling mechanism 7 and the second travelling mechanism 8 are movable along the travelling rails 6. There are two upper travelling wheels 13 and two lower travelling wheels 14, totally four wheels, to cooperate with the travelling rails 6, which may effectively improve the travelling stability. Of course, the solution including three wheels or more than four wheels may also be available herein.

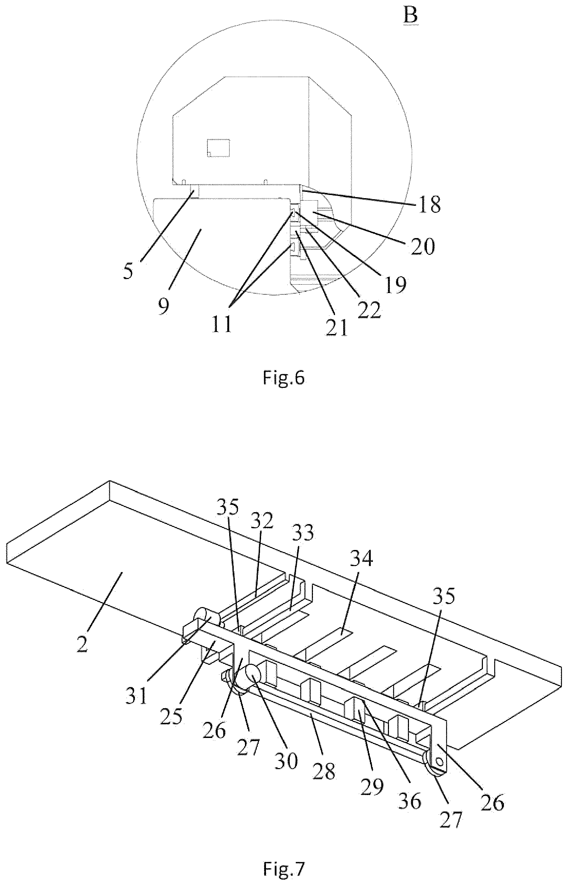

As shown in Fig. 3 and Fig. 6, the third travelling mechanism 10 includes a second frame 18, a slider 19, and a second servo motor 20. Both the slider 19 and the second servo motor 20 are fixedly installed on the second frame 18. The second travelling rail 11 has a dual rail structure. The slider 19 is slidably mounted on the second travelling rail 11. The cross-sectional shape of the travelling rail 11 is preferably trapezoidal. The corresponding slider 19 also has a trapezoidal groove. A side of the cross beam 9 is provided with a second rack 21 arranged parallel to the second travelling rail 11. A second output gear 22 is arranged on the output shaft of the second servo motor 20, and is engaged with the second rack 21. The laser sensor 5 is fixedly disposed on the second frame 18, and more specifically, the second frame 18 includes a vertical portion and a horizontal portion, both of which form an L-shaped structure. The slider 19 and the second servo motor 20 are disposed on the vertical portion, and the horizontal portion is located above the cross beam and is parallel to the cross beam 9. The laser sensor 5 is fixed on the bottom surface of the horizontal portion and bypasses the region of the cross beam 9. A sensing end of the laser sensor 5 faces the top surface of the load plate 2.

In order to realize fully-automatic control, as shown in Fig. 5, a groove 23 is opened on one of the load plates 2, and located at a feeding end of the load plate 2. The groove 23 is provided with a position sensor 24 therein. When the conveying belt 3 moves the substrate to the position of the position sensor 24, the position sensor 24 starts to collect information. When the substrate completely passes through the position sensor 24, it can be learned that the substrate has moved to a preset position. At this time, the conveying belt 3 may be stopped by the controller, it is the time to start to collect information of the substrate size. The presence of the position sensor 24 increases automation level of the present disclosure.

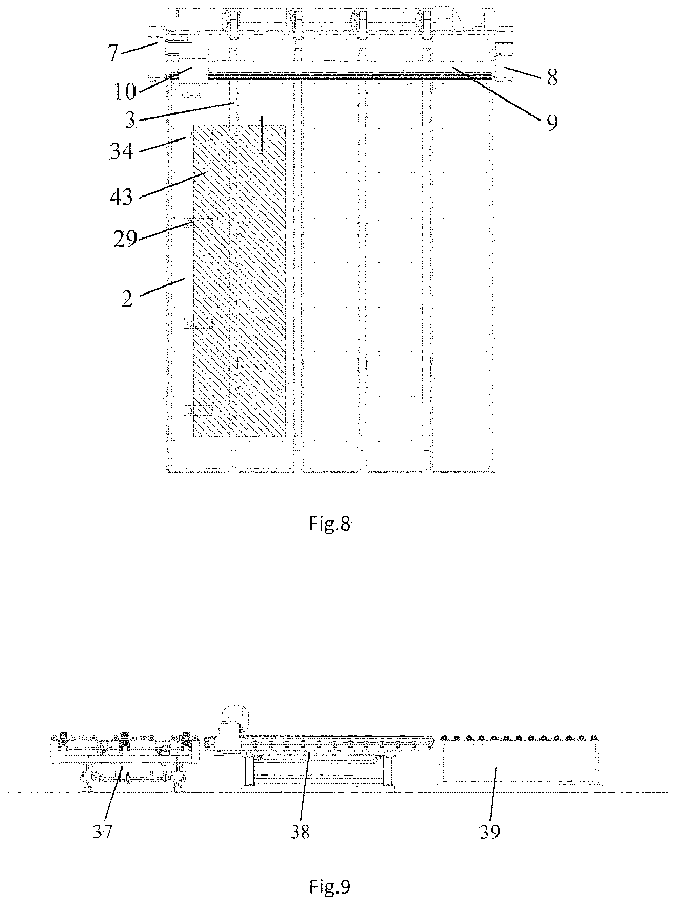

In practical use, as shown in Fig. 8, when the substrate 43 is moved to a preset position by the conveying belt 3, it is usually difficult to maintain the edge of the substrate 43 in flush with the edge of the load plate 2. In this state, the dimension information may be normally collected, but this will cause a certain error. In order to eliminate the error, as shown in Fig. 7 and Fig. 8, the present disclosure also provides a positioning mechanism. The positioning mechanism is disposed at the bottom portion of the outermost load plate 2. The positioning mechanism is mounted at the bottom portion of the load plate 2 via the fourth travelling mechanism, and can move in the width direction of the load plate 2. A plurality of through holes 34 are arranged on the plate surface of the load plate 2 at equal intervals along the length direction. Each of the through holes 34 is arranged along the width of the load plate 2. The positioning mechanism includes a third frame 25, a cam mounting rod 26, a cam 27, a support rod 28, a push rod 29, and a third servo motor 30. Guide holes 36 corresponding to the through holes 34 respectively are provided on the top rod of the third frame 25. One push rod 29 is mounted in each of the guide holes 36. There are two cam mounting rods 26 that are fixedly disposed at the bottom portion of the third frame 25. One cam 27 is mounted at the bottom portion of each of two cam mounting rods 26. The support rod 28 is located directly under the guide hole 36, and has two ends that are respectively connected with two cams 27 by a hinge. A third servo motor 30 is disposed on one of the cam mounting rods 26, for driving the cam 27 on the cam mounting rod 26. The bottom portion of the push rod 29 abuts against the top surface of the support rod 28. The fourth travelling mechanism includes a fourth servo motor 31, a third rack 32, and a third travelling rail 33. There are two third travelling rails 33 that are arranged along the width direction of the load plate 2. Two sliding sleeves 35 are provided on the top portion of the third frame 25, and are respectively sleeved on the two third travelling rails 33. The third rack 32 is also fixed on the bottom surface of the load plate 2, and is parallel to the third travelling rail 33. The fourth servo motor 31 is fixed on the top portion of the third frame 25, and is engaged with the third rack 32.

A working principle of the positioning mechanism is presented as follows: the third servo motor 30 rotates the cam 27. The cam 27 rotates synchronously with the cam 27 on the other side through the support rod 28. Since the cam is used, the motion track of the support rod 28 has a highest point and a lowest point. When the support rod 28 moves to the highest point, the support rod 28 pushes all the push rods 29 up to the highest point. At this time, the top portions of the respective push rods 29 extend from the respective through holes 34 out and above the top surface of the load plate 2 and the top surface of the substrate 43. When the support rod 28 moves to the highest point, the third servo motor 30 stops rotating, and the fourth servo motor 31 starts to work. By means of the cooperation between the fourth servo motor 31 and the third rack 32, the third frame 25 travels along the third travelling rail 33. At this time, the respective push rods 29 move along the length of the through hole 34 and push the edge of the base plate 43 to move, so that the substrate is straightened, that is, the long side of the substrate is parallel to the long side of the load plate 2. Then, the fourth servo motor 31 rotates in a reverse direction, the third servo motor 30 rotates in the reverse direction (or forward direction), the third frame 25 returns to its original position, the support rod 28 moves to the lowest point, and the respective push rods 29 are retracted under the load plate 2.

In addition to the foregoing embodiments, the present disclosure also presents some auxiliary arrangements. As shown in Fig. 1, the load plate 2 has a hollow structure, and a plurality of air holes 40 are opened on the top portion thereof. After the substrate is adjusted to be in the place, an air suction device is used for sucking air from each load plate 2, to form a negative pressure therein, so that the substrate is firmly sucked on the load plate 2 to prevent the substrate from displacing due to external factors.

As shown in Fig. 2, guard plates 41 are provided on the bottom portions of the first travelling mechanism 7 and the second travelling mechanism 8, respectively, which can effectively prevent clothes of workers from getting involved in the mechanical mechanism, so as to ensure the personal safety of the workers.

A substrate detection line, as shown in Fig. 9, includes an automatic feeding device 37, a substrate size detecting device 38, and a material output station 39, which are connected in sequence. The substrate size detecting device 38 uses the above-described fully-automatic device for detecting substrate size.

The automatic feeding device 37 and the material output station 39 are of prior arts and can realize automatic feeding and automatic discharging.

A structure of an existing automatic feeding device 37 is provided below. The automatic feeding device 37 includes a conveying table, a mechanical turnover boom, a travelling rail, a lifting mechanism, and an alarm device. The conveying table can be conveyed through, for example, rollers. The mechanical turnover boom is provided on the conveying table. The mechanical turnover boom is equipped with a vacuum suction cup, the vacuum suction cup can be extended and retracted, and employs an advanced double-layer adsorption structure (inner and outer layers), so that suction sheet(s) is more firm, and thereby preventing the defect of adsorption leakage caused by that the outer layer of the suction cup is broken. Each suction cup has a separate gas valve for switching control, and the number of the suction cup can be freely selected to facilitate for the loading operation requirements of various substrates. The mechanical turnover boom can slide along the travelling rail to achieve elongation and contraction. The mechanical turnover boom is provided with a sensor for sensing whether the substrate is provided on the frame and whether the frame is close to the substrate. The mechanical turnover boom is mechanically turned over, and the operation speed is fast (the fastest loading speed is 35 seconds/sheet) and stable without any shake, and can meet the loading of the substrate with a thickness of 1mm-12mm. A dual-channel turnover transmission chain protection is provided, which can ensure the turnover process safe and reliable. The turnover boom is controlled by a servo motor, which not only satisfies the customer's requirement for speed, but also makes the turnover boom mechanism more stable and reliable. The turnover angle is adjustable in a range of 95 degrees-110 degrees to meet various requirements for loading angle of the substrate. The alarm device, specifically the traffic light alarm device, alarms according to a result of the sensor, and can automatically alarm and display when the abnormal situation occurs. The alarm device has a switch for emergency stop, which can be controlled when an abnormal situation occurs. The lifting mechanism is used for preventing the distance between the substrates stacked on a substrate rack from being too short and thereby pressing against the adjacent substrate during the turnover process, when the mechanical turnover boom is used to suck the substrates. With the lifting mechanism, the sucked substrate is lifted and then reversed, and the sensor on the boom is used to detect whether it is lifted to a proper height so as to avoid colliding other substrates. After the substrate is sucked, the turnover boom frame is turned over horizontally and placed on the conveying table. Then the vacuum suction cup on the turnover boom frame loses the suction force, and the substrate is separated from the suction cup. A positioning structure will be provided on the conveying table so that the substrate is placed in a proper position on the conveying table each time. The lifting mechanism may be a structure composed of a motor and a mechanical rod.

The existing material output station 39 has a conveying device and a rotating device. When the substrate size is acceptable, the conveying device is opposite to the next processing station. The conveying device sends the substrate to the next station for further processing. When the substrate size exceeds an error value and is not acceptable, the conveying device is rotated 90 degrees by the rotating device to be in flush with a branch processing station, and the substrate is sent to the base of the branch processing station, waiting to be unloaded.

The present disclosure also provides a method for detecting the above-described substrate detection line, comprising the following steps:
taking pieces: the automatic feeding device 37 picks up the substrate 43 from the material rack, reverses the substrate 43 from the vertical direction to the horizontal direction, and horizontally places the substrate 43 on the substrate size detecting device 38;
detecting size: the conveying belt 3 on the substrate size detecting device 38 transports the substrate 43 to a preset position, and the laser sensor 5 scans the four sides of the substrate 43 one by one, and sends the collected data to the data processing device and calculates the length, width, and diagonal dimension of the substrate 43 by the data processing device, and compares the calculation results with preset values to determine whether the substrate 43 is qualified in size;
discharging pieces: the conveyor 3 conveys the substrate 43 to the material output station 39; the material output station 39 conveys the substrate 43 according to the detection result fed back by the data processing device; when the size of the substrate 43 is qualified, the substrate 43 is transferred to the next station; and when the size of the substrate 43 is unqualified, it is rotated 90 degrees and transferred to the branch processing station.

In the above method, when the size detection is performed, the following steps are further included. When the substrate 43 is placed on the conveying belt 3, the conveying belt 3 moves with the substrate 43 while the substrate 43 passes the position sensor 24. When the tail portion of the substrate 43 leaves from the position sensor 24, the conveying belt 3 stops operating. At this time, the substrate 43 is located at the detecting position. In order to improve accuracy of the size detection, the positioning mechanism starts working at this moment. The push rod 29 of the positioning mechanism extends out of the through hole 34 under action of the third servo motor 30, and is higher than the top surface of the base plate 43. At the same time, under the action of the fourth servo motor 31, the push rod 29 moves along the length direction of the through hole 34 and pushes the edge of the base plate 43 to be aligned with the base plate 43. Then, the cross beam 9 is driven by the two first servo motors 15 to make an oblique motion at a 45 degree, so as to roughly determine the approximate range of the lower substrate, and then returns to the middle of the substrate, and begins to scan the four sides of the substrate 43 one by one. At least two end points of each edge of the substrate 43 are scanned to determine the range of the edges of the substrate 43. Finally, the data processing device automatically synthesizes the coordinate values of the distance position of the substrate and performs four operations to determine the length, the width and the diagonal of the substrate 43. Finally, the data processing device compares the size of the substrate with the size as set in advance by the user to determine whether to meet the size requirements.

The configurations, features, and effects of the present disclosure have been described in detail with reference to the embodiments as shown in the drawings. The above-described embodiments are only the preferred embodiments of the present disclosure, but the present disclosure is not limited to the implementation scope as shown in the drawings. Any changes made according to the conception of the present disclosure, or equivalent embodiments that are modified to equivalent variations, which do not exceed the spirit covered by the description and the drawings, should be embraced by the protection scope of the present disclosure.

## Claims

1. A fully-automatic device for detecting substrate size, comprising a main frame (1), a plurality of load plates (2), at least one conveying belt (3), a gate-type travelling mechanism (4), a laser sensor (5), two travelling rails (6), and a third travelling mechanism (10);
wherein the plurality of load plates (2) are fixed on the main frame (1) at an equal distance; one of the at least one conveying belt (3) is disposed between the two of the plurality of load plates (2) adjacent to each other; the travelling rails (6) are arranged on two of the plurality of the load plates (2) located on both sides of the main frame (1) and along a length direction of the load plates (2); the gate-type travelling mechanism (4) is mounted on the travelling rails (6); and the laser sensor (5) is mounted on the gate-type travelling mechanism (4) through the third travelling mechanism (10).

2. The fully-automatic device for detecting substrate size according to claim 1, wherein the gate-type travelling mechanism (4) comprises a first travelling mechanism (7), a second travelling mechanism (8) and a cross beam (9); the cross beam (9) is located above the load plates (2); and the first travelling mechanism (7) is fixedly installed at one end of the cross beam (9), and the second travelling mechanism (8) is fixedly installed at another end of the cross beam (9); the first travelling mechanism (7) and the second travelling mechanism (8) respectively cooperate with the two travelling rails (6); a second travelling rail (11) is provided on one side of the cross beam (9); the third travelling mechanism (10) is mounted on the second travelling rail (11); and the laser sensor (5) is fixedly installed on the third travelling mechanism (10).

3. The fully-automatic device for detecting substrate size according to claim 2, wherein each of the travelling rails (6) has a monorail structure fixed on an outer side of one of the plurality of load plates (2); the first travelling mechanism (7) has the same structure as the second travelling mechanism (8), the first travelling mechanism (7) and the second travelling mechanism (8) comprise a first frame (12), two upper travelling wheels (13), two lower travelling wheels (14) and a first servo motor (15); the two upper travelling wheels (13) and the two lower travelling wheels (14) are installed at a lower part of an inner side surface of the first frame (12); the two upper travelling wheels (13) are connected with top surfaces of the travelling rails (6) in a rolling manner; the two lower travelling wheels (14) are connected with bottom surfaces of the travelling rails (6) in a rolling manner; a first rack (16) is further provided on an outer side surface of one of the load plates (2); the first servo motor (15) is also fixedly disposed on the inner side surface of the first frame (12); a first output gear (17) is provided on an output shaft of the first servo motor (15), and is engaged with the first rack (16).

4. The fully-automatic device for detecting substrate size according to claim 2, wherein the third travelling mechanism (10) comprises a second frame (18), a slider (19) and a second servo motor (20), wherein the slider (19) and the second servo motor (20) are both fixedly installed on the second frame (18), and the second travelling rail (11) has a dual rail structure and the slider (19) is slidably mounted on the second travelling rail (11), and a side of the cross beam (9) is also provided with a second rack (21) arranged in parallel with the second travelling rail (11), and a second output gear (22) is provided on an output shaft of the second servo motor (20), and the second output gear (22) is engaged with the second rack (21), and the laser sensor (5) is fixedly disposed on the second frame (18).

5. The fully-automatic device for detecting substrate size according to any one of claims 1 to 4, wherein a groove (23) is opened on one of the plurality of load plates (2), and the groove (23) is located at a feeding end of the plurality of load plates (2), and a position sensor (24) is provided in the groove (23).

6. The fully-automatic device for detecting substrate size according to any one of claims 1 to 4, wherein a positioning mechanism is provided at a bottom portion of the outermost one of the plurality of load plates (2); the positioning mechanism is mounted at the bottom portion of the outermost one of the plurality of the load plates (2) through the fourth travelling mechanism, and is capable of moving in a width direction of the load plates (2); a plurality of through holes (34) are arranged on the surface of one of the load plates (2) at equal distances along a length direction thereof; and each of the through holes (34) is arranged in a width direction of the load plates (2); the positioning mechanism comprises a third frame (25), two cam mounting rods (26), two cams (27), a support rod (28), a plurality of push rods (29), and a third servo motor (30); a plurality of guide holes (36) corresponding to the through holes (34) one by one are provided on a top rod of the third frame (25); one of the push rods (29) is mounted in each of the guide holes (36); the two cam mounting rods (26) are fixedly disposed at a bottom portion of the third frame (25); one of the cams (27) is mounted at a bottom portion of each of the two cam mounting rods (26); the support rod (28) is located directly under the guide holes (36);one end of the support rod (28) is connected with one of the two cams (27) by one hinge and another end of the support rod (28) is connected with the other of the two cams (27) by another hinge; and the third servo motor (30) is disposed on one of the cam mounting rods (26), for driving the cam (27) mounted on one of the cam mounting rods (26).

7. The fully-automatic device for detecting substrate size according to claim 6, wherein the fourth travelling mechanism comprises a fourth servo motor (31), a third rack (32) and two third travelling rails (33);the two third travelling rails (33) are arranged in the width direction of the load plates (2); two sliding sleeves (35) are provided on the top portion of the third frame (25); the two sliding sleeves (35) are respectively sleeved on the two third travelling rails (33); the third rack (32) is also fixed on the bottom surface of the load plates (2) and is parallel to the two third travelling rails (33); and the fourth servo motor (31) is fixed on the top portion of the third frame (25) and is engaged with the third rack (32).

8. A substrate detection line comprising an automatic feeding device (37), a substrate size detecting device (38) and a material output station (39) which are connected in sequence, wherein the substrate size detecting device (38) adopts fully-automatic device for detecting substrate size any one of claims 1-7.

9. The substrate detection line according to claim 8, wherein it further comprises an alarm device; the alarm device is a traffic light alarm device, and is fixed on the automatic feeding device (37).

10. A detecting method applied in the detection line as claimed in claim 8 or 9, wherein it comprises the following steps:
taking pieces procedure, in which the automatic feeding device (37) picks up a substrate (43) from a material rack, reverses the substrate (43) from the vertical direction to the horizontal direction, and horizontally places the substrate (43) on the substrate size detecting device (38);
detecting size procedure, in which a conveying belt (3) on the substrate size detecting device (38) transports the substrate (43) to a preset position, and a laser sensor (5) scans the four sides of the substrate (43) one by one, and sends the collected data to a data processing device and calculates a length, width, and diagonal dimension of the substrate (43) by the data processing device, and compares the calculation results with preset values to determine whether the substrate (43) is qualified in size;
discharging pieces procedure, in which the conveyor (3) conveys the substrate (43) to the material output station (39), and the material output station (39) conveys the substrate (43) according to the detection result fed back by the data processing device, wherein when the size of the substrate (43) is qualified, the substrate (43) is transferred to a next station, and when the size of the substrate (43) is unqualified, the substrate (43) is rotated by 90 degrees and transferred to a branch processing station.
